(19) Europäisches Patentamt
European Patent Office
Office européen des brevets

(11) **EP 2 388 142 B2**

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**19.06.2019 Patentblatt 2019/25**

(45) Hinweis auf die Patenterteilung:
**11.11.2015 Patentblatt 2015/46**

(21) Anmeldenummer: **11162924.2**

(22) Anmeldetag: **19.04.2011**

(51) Int Cl.:
*B41F 15/38* ^(2006.01)   *B41C 1/14* ^(2006.01)
*B41N 1/24* ^(2006.01)   *G03F 7/12* ^(2006.01)
*H05K 3/12* ^(2006.01)

(54) **Flächiges Siebmaterial und Sieb**

Screen material and structure of a screen printing form

Matériau et structure d' un pochoir sérigraphique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.05.2010 DE 102010021062**

(43) Veröffentlichungstag der Anmeldung:
**23.11.2011 Patentblatt 2011/47**

(73) Patentinhaber: **Gallus Ferd. Rüesch AG**
**9019 St. Gallen (CH)**

(72) Erfinder:
• **Brocker, Heinz**
 **9100 Herisau (CH)**
• **Frick, Hans-Rudolf**
 **9100 Herisau (CH)**

• **Forrer, Rolf**
 **9425 Thal (CH)**
• **Greutmann, Roland**
 **9037 Speicherschwende (CH)**

(74) Vertreter: **Haust, Christof et al**
 **Heidelberger Druckmaschinen AG**
 **Gutenbergring**
 **69168 Wiesloch (DE)**

(56) Entgegenhaltungen:
WO-A1-92/05958     WO-A1-95/17534
AT-B- 178 619      DE-A1- 19 726 869
DE-T2- 69 108 040  FR-A1- 2 225 231
FR-A5- 2 188 501   GB-A- 1 240 248
GB-A- 1 332 046    US-A- 1 934 643
US-A- 3 871 411

EP 2 388 142 B2

**Beschreibung**

Die Erfindung betrifft ein Siebmaterial mit den oberbegrifflichen Merkmalen von Anspruch 1 und ein Sieb mit den oberbegrifflichen Merkmalen von Anspruch 5.

Stand der Technik

Die industrielle Anwendung von Sieben und Geweben ist aus verschiedenen Fachgebieten bekannt. Bei der Anwendung im Bereich der Filtration ist die quadratische Maschenform die übliche Ausführungsform. Für die Druckanwendung hat man diese Maschenform übernommen. Mit den verfügbaren Fotoschichten und den bekannten Auftragsverfahren lässt sich eine vernünftige Bildauflösung nur mit einer großen Zahl von "Abstützungen" erreichen. Deshalb werden zunehmend Gewebe mit hohen Maschenzahlen verwendet.

Beim Elektronikdruck werden möglichst dünne Siebe bzw. Gewebe mit möglichst dünnem Draht eingesetzt um einen guten Durchfluss der Pasten zu gewährleisten und um allerfeinste Bildmotive zu ermöglichen. Bei der Solarzellenbeschichtung wird ein hoher Pastenauftrag und eine präzise und feine Bildauflösung gefordert. Z.B. zum Auftragen von Leiterbahnen als Stromfinger mit möglichst geringer Abdeckung der Solarzellen, um so einen hohen Wirkungsgrad der Solarzellen sicherzustellen.

Die für den Elektronikdruck verwendeten Siebe bzw. Gewebesorten sind sehr teuer und empfindlich in der Verarbeitung, so dass sie für die Herstellung von Siebdruckplatten für den rotativen Siebdruck ungeeignet sind. Die fehlende Eignung wird auch dadurch bedingt, dass die Siebgewebe beim Rotationssieb nur in einer Richtung, nämlich der Zylinderlängsachse gespannt werden können, im Flachsiebdruck hingegen jedoch in zwei Dimensionen.

Beim Rotationssiebdruck wird die Farbe durch den hydrodynamischen Druck, welcher bei der Rotation des Siebes und bei angestellter Rakel vor der Rakelbrust entsteht, durch das Sieb transportiert. Konstruktionsbedingt lassen sich nur offene oder halboffene Rakelsysteme einsetzen, so dass der dynamische Druck von vielen Faktoren beeinflusst wird wie Viskosität, Füllmenge und Rotationsgeschwindigkeit. Durch eine Erhöhung der Rotationsgeschwindigkeit oder der Farbmenge kann der hydrodynamische Druck einfach verstärkt werden.

Ein solches Rotationssiebdruckwerk ist beispielsweise in der WO 99/19146 A1 beschrieben.

Als Grundstrukturen für Siebmaterialien werden nach dem Stand der Technik Edelstahlgewebe mit Leinenbindung verwendet. Das Verhältnis von Sieböffnung, Kontaktfläche und Gewebedicke hat sich als geeignet erwiesen. Die Dicke der Struktur, also die Gewebedicke (Ausgangsmaß vor Kalandrieren) entspricht in etwa der zweifachen Drahtstärke. Die Grundstruktur wird einem weiteren Schritt in einem Kalandrierprozess bearbeitet und so auf die gewünschte Rohgewebedicke gebracht. Auch wird so eine höhere Glätte des Siebes und damit ein geringerer Sieb- und Rakelverschleiß erreicht. Im sich anschließenden Vernickelungsvorgang wird das Gewebe zwecks einer höheren Verschleißfestigkeit verstärkt und die Abstützungspunkte im Bereich der Kreuzungspunkte vergrößert.

Ein Verfahren zur Herstellung solcher Siebmaterialien ist beispielsweise in der EP 0 182 195 A2 beschrieben.

Aus der DE 197 26 869A1 ist weiterhin ein quadratmaschiges flächiges Siebmaterial bekannt.

Um die Stabilität des Siebmaterials sicherzustellen wird eine engmaschige Struktur mit vielen Abstützpunkten gewählt. Diese aus dem Stand der Technik bekannten Siebmaterialien und Siebe weisen folgende Nachteile auf:

Beim Drucken von Motiven mit großem Flächenanteil wird die Druckgeschwindigkeit durch das Verlaufsverhalten der Farbe begrenzt. Dabei können Wolkenbildung, Druckausfälle, raue Oberflächen, welche das Überdrucken z.B. mittels Flexodruck erschweren, etc. auftreten. Auch kann es auf Grund der sogenannten Flake-Form der Farbpartikel bei engen quadratmaschigen Siebmaterialien zum Verstopfen der Öffnungen kommen. Dies beeinträchtigt dann die Druckqualität. Aus dem Patent GB 1 240 248 geht ein flächiges Siebmaterial nach dem Oberbegriff von Patentanspruch 1 hervor.

Aufgabenstellung

Die heute verwendeten Siebmaterialien, seien es nun Stahlgewebe oder elektrogeformte Gitter, sind also nur bedingt für den rotativen Siebdruck geeignet. Dies ist - wie dargestellt - dadurch begründet, dass die Siebmaterialien ursprünglich für andere Anwendungen entwickelt wurden.

Aufgabe der vorliegenden Erfindung ist es daher, ein Siebmaterial und ein Sieb zu schaffen, welche die Nachteile der aus dem Stand der Technik bekannten Siebmaterialien und Siebe nicht aufweisen und besonders für den rotativen Siebdruck geeignet sind.

Gelöst wird diese Aufgabe durch ein Siebmaterial mit den Merkmalen von Anspruch 1 und durch ein Sieb mit den Merkmalen von Anspruch 5. Diese sind besonders vorteilhaft, da sie den spezifischen Anforderungen des rotativen Siebdrucks Rechnung tragen und somit eine hohe Druckgeschwindigkeit bei hoher Druckqualität ermöglichen.

Das flächige Siebmaterial, welches zu Anwendungen im Siebdruck und insbesondere im Rotationssiebdruck geeignet ist, besitzt winklig zueinander angeordnete Stege, welche eine Siebstruktur bilden. Erfindungsgemäß wird durch die Stege dabei eine Struktur, d.h. ein Gerüst in Form einer Masche mit länglichen Öffnungen gebildet. Die längliche Form der Öffnung erlaubt einen verbesserten Farbfluss.

Erfindungsgemäß bestehen die Stege an ihren Oberflächen aus Metall, wobei Nickel besonders vorteilhaft und daher bevorzugt ist. Das Metall wurde in einem Galvanisierungsprozess auf den Stegen abgeschieden.

Erfindungsgemäß sind die länglichen Öffnungen derart geformt, dass diese in Richtung der Längsachsen der Öffnungen eine größere Weite aufweisen als die Weite in Richtung der Querachsen der Öffnungen. Diese erfindungsgemäße Ausgestaltung der Öffnungen hat im Vergleich zu üblichem Siebmaterial nach dem Stand der Technik den Vorteil, dass durch die größere Sieböffnung der Farbdurchfluss wesentlich erleichtert wird.

So beträgt in einer vorteilhaften Ausführungsform die offene Siebfläche A0 der Siebstruktur zwischen 20 % und 40 %. Bei der offenen Siebfläche A0 handelt es sich dabei um das Verhältnis der offenen Fläche, d. h. der Öffnungen, zur Gesamtfläche des Siebmaterials.

Vorteilhafterweise ist die Anzahl an Öffnung pro 25,4 mm (Inch), d.h. pro englischem Zoll, der Siebstruktur in Richtung der Längsachsen der Struktur zwischen 20 und 400, insbesondere zwischen 40 und 300, und in Richtung der Querachsen der Struktur zwischen 50 und 600, insbesondere zwischen 60 und 400. Werden die Öffnungen durch Maschen gebildet, so wird von Maschen pro Inch gesprochen - die dafür verwendete Einheit ist Mesh und berechnet sich wie folgt:

Anzahl Maschen je englischem Zoll [Mesh] = 25,4 mm / p [mm]

wobei p die Teilung ist, d.h. der Abstand der Mittelachsen zweier Drähte in Millimeter.

In einer nicht erfindungsgemässen Ausführungsvariante ist die Siebstruktur des flächigen Siebmaterials einteilig geformt. Dies wird durch solche Fertigungsverfahren erreicht, mittels welcher sich homogene und poröse Flächengebilde herstellen lassen: Durch ein- oder mehrstufige Elektroformung mit additivem Aufbau, wie z.B. Galvanik, oder durch ein- oder mehrstufige photomechanische Verfahren mit einem subtraktiven Materialabtrag, wie z.B. durch Ätzen, oder durch mechanische Verfahren wie Fräsen, Schneiden und/oder Abtragen mittels Laser oder Wasserstrahl, durch Stanzen, Bohren, stereolitografisches Formen oder durch Formbildung durch Sintern, Drucken, Gießen oder Aufschäumen. Als Herstellungsmaterialien zur Bildung der flächigen Siebstruktur können dabei Metalle, vorzugsweise Nickel, homogene Kunststoffe oder auch faserverstärkte Kunststoffe oder Kombinationen von Kunststoff und Metall zum Einsatz kommen.

Erfindungsgemäss wird das flächige Siebmaterial durch ein Gewebe gebildet, z. B. durch ein Kunststoffgewebe oder ein Metalldrahtgewebe und die Stege werden durch Stränge geformt. Die von den Stegen gebildete Struktur hat dann die Form von sogenannten Langmaschen in Form von Rechteckmaschen.

Die Siebstruktur weist dabei die Form einer 1:1-Leinenbindung, einer sogenannten glatten Bindung, auch als einfache Bindung gekennzeichnet, auf. Alternativ kann die Siebstruktur die Form einer Köperbindung aufweisen, insbesondere einer 2:1, 3:1 oder 4:1 Bindung, auch bezeichnet 3-, 4- oder 5-Köperbindung. Die Stränge, welche die Langmaschen bilden, werden als Kettdrähte und Schussdrähte bezeichnet. Bei einer 1:1 Leinenbindung wird ein Kettdraht abwechselnd oberhalb und unterhalb der Schussdrähte geführt. Bei einer Köperbindung mit 2:1 bzw. 3:1 bzw. 4:1 Bindung wird ein Kettdraht abwechselnd oberhalb von zwei bzw. drei bzw. vier Schussdrähten und dann unterhalb von einem Schussdraht geführt. Erfindungsgemäss sind die Schussdrähte im Wesentlichen gerade und liegen in einer Ebene.

Zur Notation x : y Bindung existieren alternative Notationen: x/y-Bindung und x-y Bindung. Weiterhin vorteilhaft ist es, wenn Kettdrähte und Schussdrähte den gleichen Durchmesser aufweisen.

Die Erfindung betrifft auch ein Sieb für den Rotationssiebdruck, welches aus einem flächigen Siebmaterial, wie oben beschrieben, hergestellt ist und wobei das Sieb die Form einer zylindrischen Hülse besitzt. In vorteilhafter Weise ist die größte Weite der Öffnungen der durch die Stege gebildeten Struktur in etwa in Umfangsrichtung des Siebes orientiert. In vorteilhafter Weise wird so ein guter Farbdurchfluss des Siebes gewährleistet, da den Farbpartikeln ein geringerer Widerstand entgegengesetzt wird und auch große Farbpartikel, welche eine sogenannte "flake form" aufweisen, die länglichen Öffnungen der Struktur einfacher passieren können und ein Verstopfen des Siebes so vermieden wird. Alternativ oder zusätzlich können die Längsachsen der Struktur in einem spitzen oder stumpfen Winkel zu der Umfangsrichtung des Siebes ausgerichtet sein. Dadurch ist in vorteilhafter Weise gewährleistet, dass der sogenannte "Parallelkanteneffekt" eines im Rotationssiebdruck verwendeten Rakels wesentlich reduziert werden kann: bei Druckmotiven, deren Kanten parallel zur Rakelkante verlaufen, kann so die Druckqualität bedeutend erhöht werden.

In einer vorteilhaften Weiterbildung des erfindungsgemäßen Siebs ist das flächige Siebmaterial einseitig mit einer Polymerschicht, insbesondere mit einer Fotopolymerschicht, versehen, sodass eine Bebilderung nach dem Fachmann bekannten Verfahren ermöglicht wird.

Die beschriebene Erfindung und die beschriebenen vorteilhaften Weiterbildungen der Erfindung stellen auch in beliebiger Kombination miteinander vorteilhafte Weiterbildungen der Erfindung dar.

Hinsichtlich weiterer Vorteile und vorteilhafter Ausgestaltungen der Erfindung wird auf die Unteransprüche sowie die Beschreibung eines Ausführungsbeispiels unter Bezugnahme auf die beiliegenden Zeichnungen verwiesen.

Ausführungsbeispiel

Die Erfindung soll an Hand eines Ausführungsbeispiels noch näher erläutert werden. Es zeigen in schematischer Darstellung

Fig.1        das erfindungsgemäße Siebmaterial

Fig. 2a        eine Draufsicht auf ein flächiges Siebmaterial in 2:1 Köperbindung

Fig. 2b        Schnittdarstellungen des Siebmaterials aus **Fig. 2a** durch die Schussdrähte

Fig. 2c        Schnittdarstellungen des Siebmaterials aus **Fig. 2a** durch die Kettdrähte

Fig. 3a        eine Draufsicht auf ein Siebmaterial in 1:1 Leinenbindung

Fig. 3b        Schnittdarstellungen des Siebmaterials aus **Fig. 3a** durch die Kettdrähte

Fig. 3c        Schnittdarstellungen der Siebstruktur aus **Fig. 3a** durch die Schussdrähte

Figuren 4a, b, c        Zwei Schnittdarstellungen und eine Draufsicht auf ein Siebmaterial in 1:1 Leinenbindung nach erfolgtem Kalandrierprozess, die nicht Teil der Erfindung sind

Fig. 5a        verschiedene mögliche Grundformen der länglichen Öffnung der Struktur in einem Schattenwurf, d.h. in einer Draufsicht, wobei nur die rechteckige Form Teil der Erfindung ist

Fig. 5b        verschiedene Grundformen der Öffnungen der Struktur in einer Schnittdarstellung durch das Siebmaterial senkrecht zur Oberfläche des Siebes

Fig. 6        ein Sieb für den Rotationssiebdruck

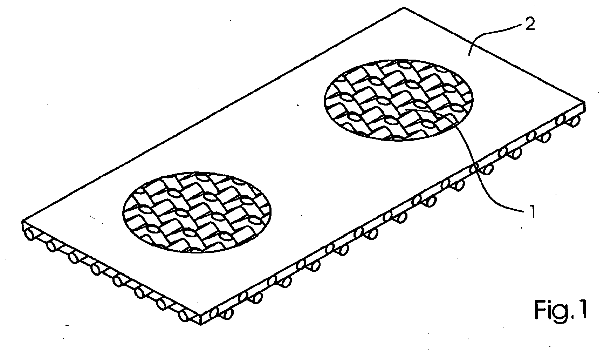

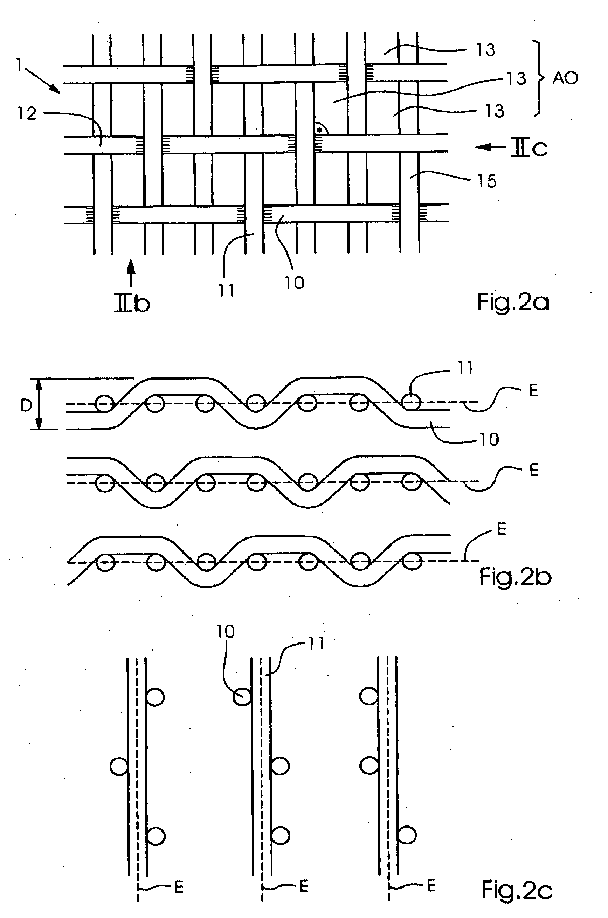

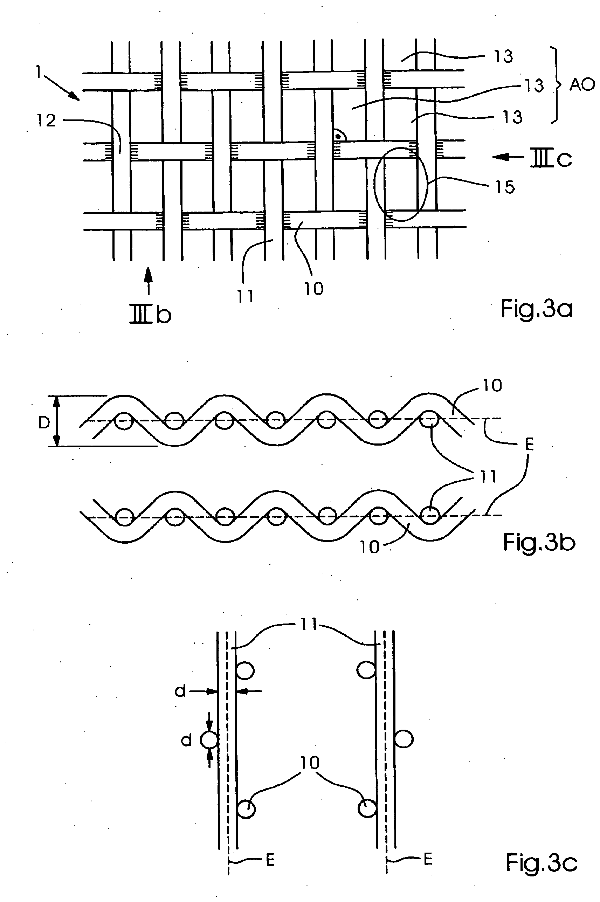

Fig. 1 zeigt ein erfindungsgemäßes flächiges Siebmaterial 1, welches einseitig mit einer Foto-Polymerbeschichtung 2 versehen ist (Direktschablone). In einer nicht dargestellten alternativen Ausführungsform kann eine bereits bebilderte Folie auf die Siebstruktur 1 aufgebracht werden (Indirektschablone). Das vernickelte flächige Siebmaterial 1 kann dabei entweder einteilig aufgebaut sein, z.B. galvanisch erzeugt, oder aus einem Gewebe bestehen. Dabei sind verschiedene Gewebeformen möglich. In den Figuren 2 ist ein Gewebe mit einer 2:1 Köperbindung dargestellt, in den Figuren 3 ist ein Gewebe mit einer 1:1 Leinenbindung dargestellt.

Wie sich aus der Draufsicht in **Fig. 2a** ergibt, bilden Kettdrähte 10 und Schussdrähte 11 Stege, welche eine Struktur 15 mit länglichen Öffnungen 13 ausbilden. Die Stege mit den Öffnungen 13 können auch als Langmaschen bezeichnet werden. In der Darstellung von **Fig. 2a** sind die Kettdrähte 10 und die Schussdrähte 11 rechtwinklig zueinander angeordnet. In **Fig. 2a** ist auch die offene Siebfläche A0 angedeutet. Die offene Siebfläche A0 berechnet sich als Verhältnis aus der Fläche der Öffnungen 13 zur Gesamtfläche des Siebmaterials, d.h. der Summe aus der Fläche der Öffnungen 13 und der Fläche der Stege 10, 11. In **Fig. 2b** sind Schnittdarstellungen durch die Kettdrähte 10 aus **Fig. 2a** dargestellt. Daraus wird ersichtlich, dass bei der 2:1 Köperbindung ein jeweiliger Kettdraht 10 abwechselnd unterhalb eines Schussdrahts 11 und dann oberhalb von zwei Schussdrähten 11 geführt wird, usw. Die Schussdrähte 11 liegen dabei alle in einer Ebene E. Dies wird auch in den Schnittdarstellungen von **Fig. 2c** durch die Schussdrähte 11 deutlich.

Das in **Fig. 3a** in einer Draufsicht dargestellte Siebmaterial 1 hat die Form einer 1:1 Leinenbindung. Die Stege 10 und 11, welche die Struktur mit länglichen Öffnungen 13 bilden, sind als Kettdrähte 10 und Schussdrähte 11 ausgeführt. Die durch die Kettdrähte 10 und Schussdrähte 11 gebildete Struktur kann als Langmasche 15 bezeichnet sein. In der Darstellung von Fig. 3a sind die Kettdrähte 10 und die Schussdrähte 11 rechtwinklig zueinander angeordnet und bilden daher rechtwinklige Langmaschen 15. Wie sich aus der Schnittdarstellung in **Fig. 3b** durch zwei Kettdrähte 10 ergibt, ist ein jeweiliger Kettdraht 10 abwechselnd oberhalb und dann wieder unterhalb eines Schussdrahts 11 geführt. Die Schussdrähte 11 liegen dabei alle in einer Ebene E. Dies ist auch aus **Fig. 3c** ersichtlich. Die Dicke D der Gewebestruktur des flächigen Siebmaterials 1 ist in **Fig. 2b** als auch 3b angegeben und beträgt erfindungsgemäss in etwa die dreifache Dicke d, d.h. entspricht dem dreifachen Durchmesser von Kettdraht 10 bzw. Schussdraht 11. Dadurch wird eine hohe Stabilität des flächigen Siebmaterials 1 erreicht. Gleiches gilt für das Siebmaterial 1 aus den **Figuren 2a-c.**

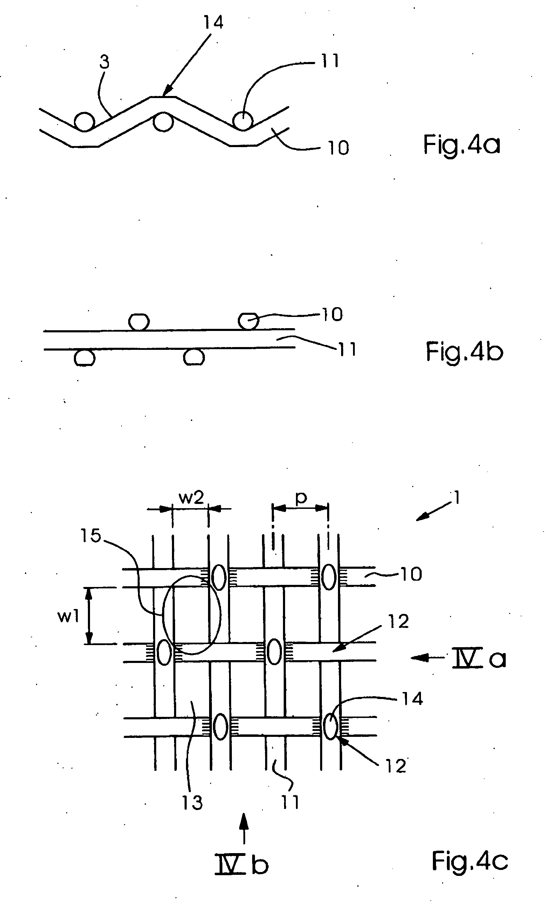

Die **Figuren 4a bis c** sind nicht Bestandteil des Patents und zeigen ein flächiges Siebmaterial 1, nach dem dieses einem Kalandriervorgang unterzogen wurde. In den Kreuzungspunkten 12 von Kettdrähten und Schussdrähten 11 wurde das Siebmaterial geplättet, so dass Auflageflächen 14 gebildet wurden. In **Fig. 4c** sind weiter die Abmaße einer Langmasche 15 angezogen: Dabei beschreibt w1 die Maschenweite in Längsrichtung der Öffnung 13 und w2 die Maschenweite in Querrichtung der Öffnung 13. Der Abstand der Mittelachsen zweier Drähte 10 bzw. 11 wird als Teilung p bezeichnet.

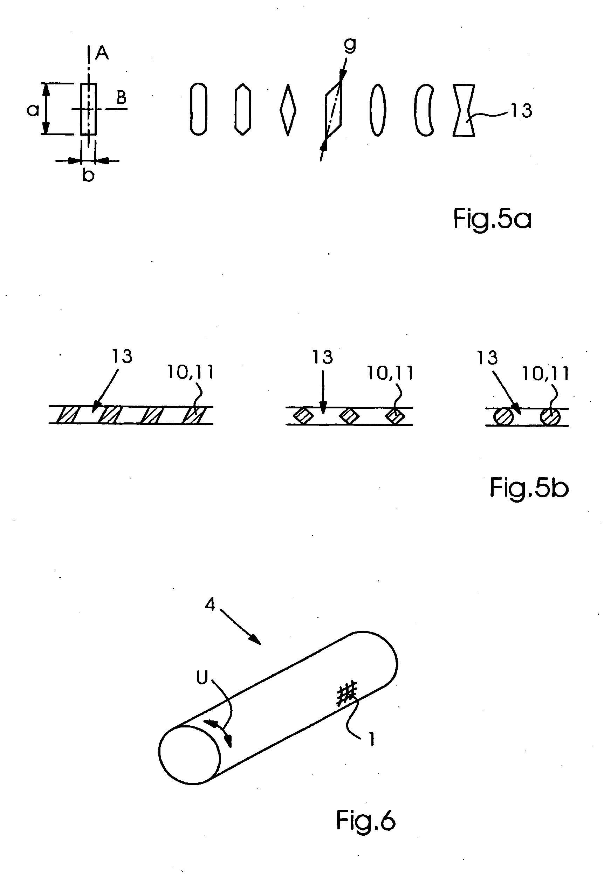

Die Länge a einer Öffnung 13 in Richtung der Längsachse A ist dabei jeweils größer als die Breite b der Öffnung 13 in Richtung der Querachse B. Die größte Weite einer jeweiligen Öffnung 13 wird mit g bezeichnet. Zur Erfindung gehört in **Fig. 5a** die rechteckige Ausformung. Wie in **Fig. 5b** beispielhaft dargestellt, können die Öffnungen 13 der Struktur 15 des flächigen Siebmaterials 1 auch unterschiedliche Schnittprofile aufweisen, so z.B. schräg verlaufende Profile. Dadurch ist eine weitere Optimierung des Farbflusses durch das Siebmaterial 1 möglich.

In Fig. 6 ist ein Sieb 4 mit einem flächigen Siebmaterial 1 in zylindrischer Hülsenform für den rotativen Siebdruck angedeutet. Das Siebmaterial 1 wird dabei durch nicht näher bezeichnete Endstücke in seiner zylindrischen Form gehalten. Im Innern des Siebs 4 befindet sich ein nicht sichtbares Rakel um Farbe durch das Siebmaterial zu pressen. Die Ausrichtung des Rakels kann parallel zur Rotationsachse des Siebes 4 sein. Die Umfangsrichtung U des Siebes 4 ist dabei mit einem Doppelpfeil angedeutet. Die größte Weite g der Öffnungen 13 (siehe Fig. 5a) kann in etwa in dieser Umfangsrichtung U orientiert sein, wodurch ein guter Farbdurchfluss, auch als Farbübertragsverhalten bezeichnet, gewährleistet wird. Die Längsachsen A der Öffnungen 13 (siehe Fig. 5a) können nicht-rechtwinklig zu dieser Umfangsrichtung U ausgerichtet sein, was den sogenannten Parallelkanteneffekt reduziert.

Die größte Weite g der Öffnungen 13 kann in einer alternativen (nicht dargestellten) Ausführungsform in etwa 90° verdreht zu der Umfangsrichtung U ausgerichtet sein, wodurch der Farbdurchfluss gezielt reduziert werden kann. Die Ausrichtung der größten Weite g der Öffnungen 13 relativ zur Umfangsrichtung U ermöglicht also einen gezielten Farbdurchfluss.

**Bezugszeichenliste**

| 1 | Flächiges Siebmaterial |
|---|---|
| 2 | Polymerbeschichtung |
| 3 | Nickelbeschichtung |
| 4 | Sieb in zylindrischer Hülsenform |
| 10 | Kettdraht |
| 11 | Schussdraht |
| 12 | Kreuzungspunkt |
| 13 | Öffnung |
| 14 | Auflagefläche |
| 15 | Langmasche |

| A0 | Offene Siebfläche |
|---|---|

| a | Länge der Öffnung |
|---|---|
| A | Längsachse der Öffnung |
| b | Breite der Öffnung |
| B | Querachse der Öffnung |

| d | Durchmesser Draht |
|---|---|
| D | Dicke der Gewebestruktur |

| E | Ebene der Schussdrähte |
|---|---|

| g | Größte Weite der Öffnung |
|---|---|

| p | Teilung (Abstand der Mittelachsen zweier Drähte in mm) |
|---|---|

| U | Umfangsrichtung |
|---|---|

| w1 | Maschenweite in Längsrichtung der Öffnung |
|---|---|
| w2 | Maschenweite in Querrichtung der Öffnung |

**Patentansprüche**

1. Flächiges Siebmaterial (1) zur Anwendung im Siebdruck, insbesondere im Rotationssiebdruck, mit eine Siebstruktur bildenden, winklig zueinander angeordneten Stegen (10, 11),
   wobei die Stege (10, 11) zumindest an ihren Oberflächen aus Metall (3) bestehen, insbesondere aus Nickel, das in einem Galvanisierungsprozess auf den Stegen (10, 11) abgeschieden wurde,
   wobei die Stege (10, 11) eine Struktur (15) mit länglichen Öffnungen (13) bilden, und die Öffnungen (13) in Richtung der Längsachsen (A) der Öffnungen (13) eine größere Weite (a, w1) als die Weite (b, w2) in Richtung der Querachsen (B) der Öffnungen (13) aufweisen, und
   wobei das flächige Siebmaterial (1) ein Gewebe ist und die Stege aus Strängen (10, 11) gebildet werden und die Strukturen (15) die Form von Langmaschen aufweisen, nämlich von Rechteckmaschen,
   und wobei die Siebstruktur die Form einer 1:1 Leinenbindung oder die Form einer Köperbindung aufweist, insbesondere einer 2:1 Köperbindung,
   und wobei die Stränge Kettdrähte (10) und Schussdrähte (11) sind,
   **dadurch gekennzeichnet,**
   **dass** die Schussdrähte (11) gerade sind und in einer Ebene liegen und
   **dass** die Dicke (D) des Gewebes in etwa dem dreifachen Durchmesser (d) von Kettdrähten (10) bzw. Schussdrähten (11) entspricht.

2. Flächiges Siebmaterial nach Anspruch 1,
   **dadurch gekennzeichnet,**
   **dass** die offene Siebfläche (A0) der Siebstruktur zwischen 20% und 40% beträgt.

3. Flächiges Siebmaterial nach einem der vorangehenden Ansprüche,
   **dadurch gekennzeichnet,**
   **dass** die Anzahl Öffnungen (13) pro Inch der Siebstruktur in Richtung der Längsachsen (A) der Struktur (15) zwischen 20 und 400 liegt und in Richtung der Querachsen (B) der Struktur (15) zwischen 50 und 600 liegt.

**4.** Flächiges Siebmaterial nach Anspruch 1,
**dadurch gekennzeichnet,**
**dass** die Kettdrähte (10) und die Schussdrähte (11) den gleichen Durchmesser (d) aufweisen.

**5.** Sieb (4) für den Rotationssiebdruck aus einem flächigen Siebmaterial (1) nach einem der Ansprüche 1 bis 4,
wobei das Sieb die Form einer zylindrischen Hülse aufweist,
**dadurch gekennzeichnet,**
**dass** die größte Weite (g) der Öffnungen (13) der Struktur (15) in etwa 90° verdreht zu der Umfangsrichtung (U) des Siebes (4) ausgerichtet ist.

**6.** Sieb (4) für den Rotationssiebdruck aus einem flächigen Siebmaterial (1) nach einem der Ansprüche 1 bis 4,
wobei das Sieb die Form einer zylindrischen Hülse aufweist,
**dadurch gekennzeichnet,**
**dass** die größte Weite der Öffnungen (13) der Struktur (15) in etwa in Umfangsrichtung (U) des Siebes (4) ausgerichtet ist und / oder,
**dass** die Längsachsen (A) der Struktur (15) in einem spitzen oder stumpfen Winkel zu der Umfangsrichtung (U) des Siebes (4) ausgerichtet sind.

**7.** Sieb nach Anspruch 6,
**dadurch gekennzeichnet,**
**dass** das flächige Siebmaterial (1) einseitig mit einer Polymerschicht (2) beschichtet ist, insbesondere mit einer Photopolymerschicht.

**Claims**

**1.** Flat screen material (1) for use in screen printing, in particular in rotary screen printing, and having webs (10, 11) forming a screen structure and disposed at angles relative to one another,
wherein at least at their surfaces, the webs (10, 11) consist of metal (3), in particular of nickel, that has been deposited on the webs (10, 11) in an electroplating process,
wherein the webs (10, 11) form a structure (15) with elongated openings (13) and the width (a, w1) of the openings (13) in the direction of the longitudinal axes (A) of the openings (13) is greater than the width (b, w2) in the direction of the transvers axes (B) of the openings (13),
wherein the flat screen material (1) is a mesh and the webs are formed of threads (10, 11) and the structures (15) have the form of elongated meshes, namely of rectangular meshes,
and wherein the screen structure has the form of a 1:1 plain weave or of a twill weave, in particular a 2:1 twill weave,
and wherein the threads are warp threads (10) and weft threads (11).
**characterized in**
**that** the weft threads (11) are straight and disposed in one plane and
**that** the thickness (D) of the mesh approximately corresponds to three times the diameter (d) of warp threads (10) and/or weft threads (11).

**2.** Flat screen material according to claim 1,
**characterized in**
**that** the open screen area (A0) of the screen structure is between 20% and 40%.

**3.** Flat screen material according to any one of the preceding claims,
**characterized in**
**that** the number of openings (13) per inch of the screen structure is between 20 and 400 in the direction of the longitudinal axes (A) of the structure (15) and between 50 and 600 in the direction of the transverse axes (B) of the structure (15).

**4.** Flat screen material according to claim 1,
**characterized in**
**that** the warp threads (10) and the weft threads (11) have the same diameter (d).

**5.** Screen (4) for rotary screen printing made of a flat screen material (1) according to any one of claims 1 to 4,
wherein the screen has the shape of a cylindrical sleeve,
**characterized in**
**that** the greatest width (g) of the openings (13) of the structure (15) is oriented approximately at a 90° angle relative to the circumferential direction (U) of the screen (4).

**6.** Screen (4) for rotary screen printing made of a flat screen material (1) according to any one of claims 1 to 4,
wherein the screen has the shape of a cylindrical sleeve,
**characterized in**
**that** the greatest width of the openings (13) of the structure (15) is oriented approximately in the circumferential direction (U) of the screen (4) and/or
**that** the longitudinal axes (A) of the structure (15) are aligned at an acute or obtuse angle relative to the circumferential direction (U) of the screen (4).

**7.** Screen according to claim 6,
**characterized in**
**that** on one side, the flat screen material (1) is coated with a polymer layer (2), in particular a photopolymer layer.

**Revendications**

1. Matériau d'écran plan (1) pour utilisation en sérigraphie, notamment en sérigraphie rotative, avec des barrettes (10, 11) disposées angulairement les unes par rapport aux autres formant une structure d'écran, les barrettes (10,11) étant, au moins en surface, composées de métal (3), notamment de nickel déposé sur les barrettes (10, 11) par un procédé de galvanisation, les barrettes (10,11) présentant une structure (15) comportant des ouvertures oblongues (13) et les ouvertures (13) présentant dans le sens des axes longitudinaux (A) des ouvertures (13) une largeur (a, w1) plus importante que la largeur (b, w2) en direction des axes transversaux (B) des ouvertures (13), le matériau d'écran plan (1) étant un tissu et les barrettes constituées de brins (10, 11), les structures (15) ayant la forme de mailles longues, notamment de mailles rectangulaires, et la structure de l'écran présentant la forme d'une armure de toile 1:1 ou la forme d'une armure sergée, notamment d'une armure sergée 2:1, les brins étant des fils de chaîne (10) et des fils de trame (11), **caractérisé en ce**

   **que** les fils de trame (11) sont droits et disposés sur un plan et que l'épaisseur (D) du tissu correspond environ approximativement au triple diamètre (d) des fils de chaîne (10) et/ou des fils de trame (11).

2. Matériau d'écran plan selon la revendication 1, **caractérisé en ce**

   **que** la surface ouverte de l'écran (AO) de la structure d'écran correspond à entre 20 % et 40%.

3. Matériau d'écran plan selon l'une des revendications précédentes, **caractérisé en ce**

   **que** le nombre d'ouvertures (13) par pouce de la structure d'écran se monte, en direction des axes longitudinaux (A) de la structure (15), à entre 20 et 400 et, dans le sens des axes transversaux (B) de la structure (15), à entre 50 et 600.

4. Matériau d'écran plan selon la revendication 1, **caractérisé en ce**

   **que** les fils de chaîne (10) et les fils de trame (11) présentent le même diamètre (d).

5. Écran (4) pour la sérigraphie rotative, composé d'un matériau d'écran plan (1) selon l'une des revendications 1 à 4,

   pour lequel l'écran présente la forme d'une douille cylindrique,

   **caractérisé en ce que** la plus grande largeur (g) des ouvertures (13) de la structure (15) sont orientées d'environ 90° par rapport au sens de la circonférence (U) de l'écran (4).

6. Écran (4) pour la sérigraphie rotative, composé d'un matériau d'écran plan (1) selon l'une des revendications 1 à 4,

   pour lequel l'écran présente la forme d'une douille cylindrique,

   **caractérisé en ce**

   **que** la plus grande largeur des ouvertures (13) de la structure (15) est approximativement orientée dans le sens de la circonférence (U) de l'écran (4) et / ou que les axes longitudinaux (A) de la structure (15) sont orientés selon un angle aigu ou obtus par rapport au sens de la circonférence (U) de l'écran (4).

7. Écran selon la revendication 6, **caractérisé en ce**

   **que** le matériau de l'écran plan (1) est revêtu sur une face avec une couche de polymère (2), notamment avec une couche de photopolymère.

Fig.1

Fig.2a

Fig.2b

Fig.2c

Fig.3a

Fig.3b

Fig.3c

Fig.4a

Fig.4b

Fig.4c

Fig.5a

Fig.5b

Fig.6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9919146 A1
- EP 0182195 A2
- DE 19726869 A1
- GB 1240248 A